(19) Europäisches Patentamt
European Patent Office
Office européen des brevets

(11) **EP 1 322 038 B1**

(12) **FASCICULE DE BREVET EUROPEEN**

(45) Date de publication et mention
de la délivrance du brevet:
**21.03.2007 Bulletin 2007/12**

(51) Int Cl.:
*H03H 7/20* *(2006.01)*

(21) Numéro de dépôt: **02102700.8**

(22) Date de dépôt: **06.12.2002**

(54) **Déphaseur large bande**

Breitband Phasenschieber

Broadband phase shifter

(84) Etats contractants désignés:
**DE FR GB IT NL**

(30) Priorité: **14.12.2001 FR 0116159**

(43) Date de publication de la demande:
**25.06.2003 Bulletin 2003/26**

(73) Titulaire: **Thales**
**75008 Paris (FR)**

(72) Inventeurs:
• **DUEME, Philippe**
**Thales Intellectual Property**
**94117 CX, ARCUEIL (FR)**

• **FUNCK, Ronald**
**Thales Intellectual Property**
**94117 CX, ARCUEIL (FR)**

(74) Mandataire: **Lucas, Laurent Jacques et al**
**Marks & Clerk France**
**31-33 Avenue Aristide Briand**
**94117 Arcueil Cedex (FR)**

(56) Documents cités:
**EP-A- 0 492 653        GB-A- 725 628**
**US-A- 4 733 203**

**Description**

La présente invention concerne un déphaseur large bande. Elle s'applique notamment pour des antennes à balayage électronique. Plus généralement, elle s'applique pour tous les dispositifs hyperfréquence nécessitant un déphasage sur une large bande de fréquences.

Il est connu d'utiliser des déphaseurs dans des antennes à balayage électronique. Ces antennes comportent un réseau de cellules de déphasage commandables électroniquement. Chaque cellule de déphasage comprend un déphaseur hyperfréquence commandé par exemple sur plusieurs bits. A titre d'exemple, un déphaseur commandé par deux bits peut fournir les déphasages 0°, 90°, 180° et 270°.

Il est par ailleurs connu de réaliser des déphaseurs fonctionnant sur une large bande de fréquences. Pour couvrir une bande donnée, ces déphaseurs comportent généralement une association de déphaseurs fonctionnant en sous-bandes. Il se pose alors un problème d'encombrement, de coût, de consommation, voire de pertes de gain.

Plus généralement, il n'existe pas sur le marché de déphaseurs en circuit intégré, dits de type MMIC, couvrant l'intégralité d'une bande utile de fonctionnement, lorsque celle-ci dépasse une certaine largeur. Il est en effet très difficile de trouver des déphaseurs ou des combinaisons de déphaseurs couvrant en même temps la bande X et des fréquences inférieures à 3 GHz. Cela est notamment dû au fait que ce type de déphaseur utilise des coupleurs dit « de Lange » dont la bande de fréquence ne peut s'étendre à un rapport supérieur à 3 entre fréquences maximum et minimum, et dont la taille devient prohibitive vers 2 GHz. En contrepartie, les pertes de ces déphaseurs sont relativement faibles. Par ailleurs, ces circuits occupent des surfaces relativement importantes.

Un document US 4 733 203 A porte sur la commutation interne de cellules passe-bas et passe-haut, selon le principe connu sous le nom de « cellules à composants commutés » par opposition au déphaseur à cellules commutées.

Un but de l'invention est de pallier les inconvénients précités, notamment de permettre la réalisation d'un déphaseur fonctionnant dans une large bande de fréquence sans passer notamment par l'association de déphaseurs fonctionnant en sous-bandes. A cet effet, l'invention a pour objet un dispositif de déphasage d'un signal selon la revendication 1. Il comporte au moins un commutateur et un déphaseur élémentaire ayant deux voies parallèles A, B comprenant chacune n cellules « passe-tout ». Le commutateur aiguille le signal d'entrée vers l'une ou l'autre des voies, chaque cellule déphasant un signal selon une loi fonction de sa fréquence. Le déphasage $\Delta\varphi$ produit par un déphaseur élémentaire est obtenu en commutant le signal d'une voie à l'autre et est égal à la différence des phases des deux voies.

Pour obtenir plusieurs valeurs de déphasage, le dispositif comporte plusieurs déphaseurs élémentaires en cascade séparés chacun par un commutateur « 2 vers 2 » à quatre états, le déphasage $\Delta\varphi$ d'un déphaseur élémentaire au suivant variant par exemple d'un pas $\phi/2^N$.

Avantageusement, pour assurer un déphasage sensiblement constant à un déphaseur élémentaire sur une large bande de fréquence, les inductances des cellules « passe-tout » sont liées par une mutuelle inductance. Avantageusement, les inductances peuvent être réalisées par des spirales et la mutuelle inductance peut être réalisée par l'imbrication de ces spirales.

D'autres caractéristiques et avantages de l'invention apparaîtront à l'aide de la description qui suit faite en regard de dessins annexés qui représentent :

- la figure 1, une cellule dite « passe-tout » ;
- la figure 2, une illustration du déphasage produit sur un signal passant dans la cellule « passe-tout » en fonction de la fréquence de ce signal ;
- la figure 3, un premier exemple de déphaseur composé de deux voies comportant chacune une cellule « passe-tout » ;
- la figure 4, une illustration du déphasage entre les premières cellules de chacune des deux voies du déphaseur précédent, sur une bande de fréquences ;
- la figure 5, un deuxième exemple de déphaseur où chacune des deux voies comporte deux cellules « passe-tout » ;
- la figure 6, une illustration du déphasage entre les deux voies du déphaseur précédent, sur une bande de fréquences élargie ;
- les figures 7a à 7d, une illustration de l'allure du déphasage en fonction de la fréquence pour certaines valeurs de mutuelle inductance à l'intérieur des cellules « passe-tout » ;
- la figure 8, un exemple de réalisation possible, en spirales imbriquées, des inductances d'une cellule « passe-tout » ;
- les figures 9a et 9b, deux autres exemples de réalisation possibles en spirales des inductances ;
- la figure 10, un exemple de réalisation d'un déphaseur élémentaire comportant deux voies parallèles de cellules « passe-tout » ;
- la figure 11, un tableau indiquant à titre d'exemple plusieurs valeurs de déphasage en fonction des valeurs des composants des différentes cellules « passe-tout » composant le déphaseur;
- la figure 12, un exemple de déphaseur composé de plusieurs déphaseurs élémentaires et de commutateurs ;
- la figure 13, une courbe représentative de la puissance d'un signal traversant le déphaseur.

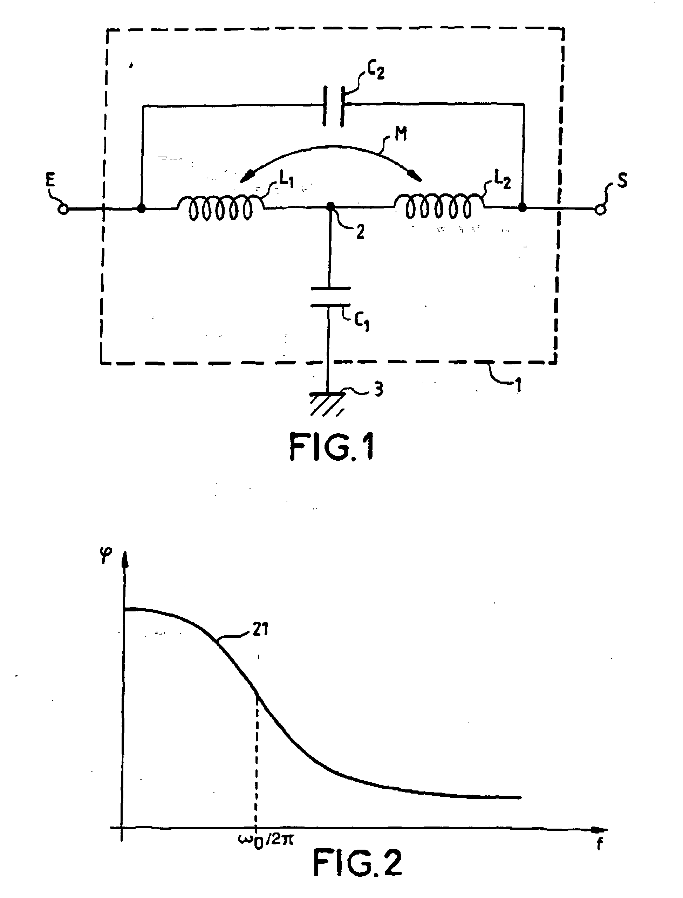

La figure 1 présente une cellule 1, dite « passe-tout », à base de condensateurs et d'inductances. Cette cellule comporte deux inductances $L_1$, $L_2$ en série. Un premier condensateur $C_1$ est relié entre le point milieu 2 des deux inductances et un potentiel de référence 3, par exemple le potentiel de masse. L'entrée E de la cellule est reliée à un pôle de la première inductance $L_1$ et la sortie S de la cellule est reliée à un pôle de la deuxième inductance $L_2$. Un condensateur de pont $C_2$ relie l'entrée E à la sortie S. Les inductances $L_1$, $L_2$ ont par exemple la même valeur d'inductance L. Elles présentent entre elles une mutuelle inductance M. La valeur relative m de cette mutuelle inductance est donnée par la relation suivante :

$$m = \sqrt{\frac{M^2}{L_1 L_2}} \qquad\qquad (1)$$

en assimilant les valeurs d'inductance aux notations de ces composants $L_1$, $L_2$ et M

La figure 2 illustre par une courbe 21 le déphasage φ induit sur un signal hyperfréquence passant dans la cellule 1. La cellule déphase ce signal selon une loi, représentée par la courbe 21, fonction de la fréquence f de ce signal. Une telle cellule ne comporte pas de fréquence de coupure en terme de gain (module de la fonction de transfert), mais provoque en effet un déphasage des signaux. Après être resté constant sur une bande de fréquences basses, le déphasage φ diminue en fonction de la fréquence pour se stabiliser asymptotiquement sur une valeur constante aux hautes fréquences. On peut définir une pulsation de transition $\omega_0$ au centre de la zone de transition de la phase, définie par la relation suivante :

$$\omega_0 = \sqrt{\frac{1+k^2}{LC}} \qquad\qquad (2)$$

k étant un paramètre de réglage compris 0 et 1.

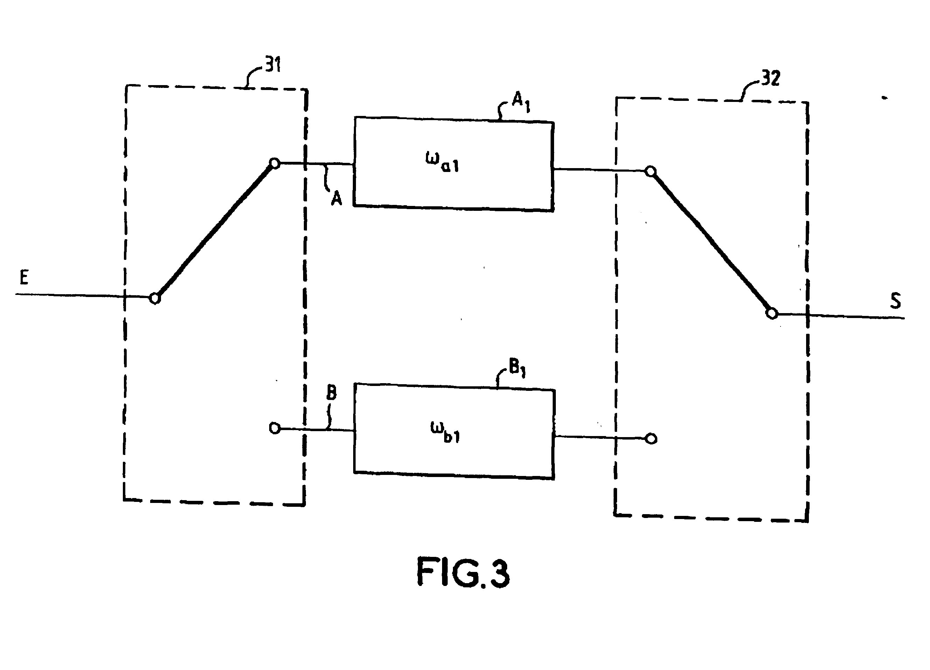

La figure 3 illustre par un schéma synoptique un premier exemple de déphaseur selon l'invention. Ce déphaseur est composé de cellules « passe-tout ». Un tel circuit comprend deux voies en parallèle comportant chacune une cellule du type de celle de la figure 1. Le déphaseur comporte dans ce cas deux cellules $A_1$, $B_1$ ayant des pulsations de transition notées respectivement $\omega_{a1}$, $\omega_{a2}$. Un premier commutateur 31 aiguille le signal d'entrée E sur l'une ou l'autre voie. Un deuxième commutateur 32, ou commutateur de sortie, aiguille la voie véhiculant le signal sur la sortie S du déphaseur. Ces commutateurs 31, 32 peuvent être actifs, c'est-à-dire à base de composants amplifiant le niveau d'énergie du signal à commuter, ou passifs. Les commutateurs actifs sont par exemple à structure distribuée composée de cellules équipées de transistors montés en cascode.

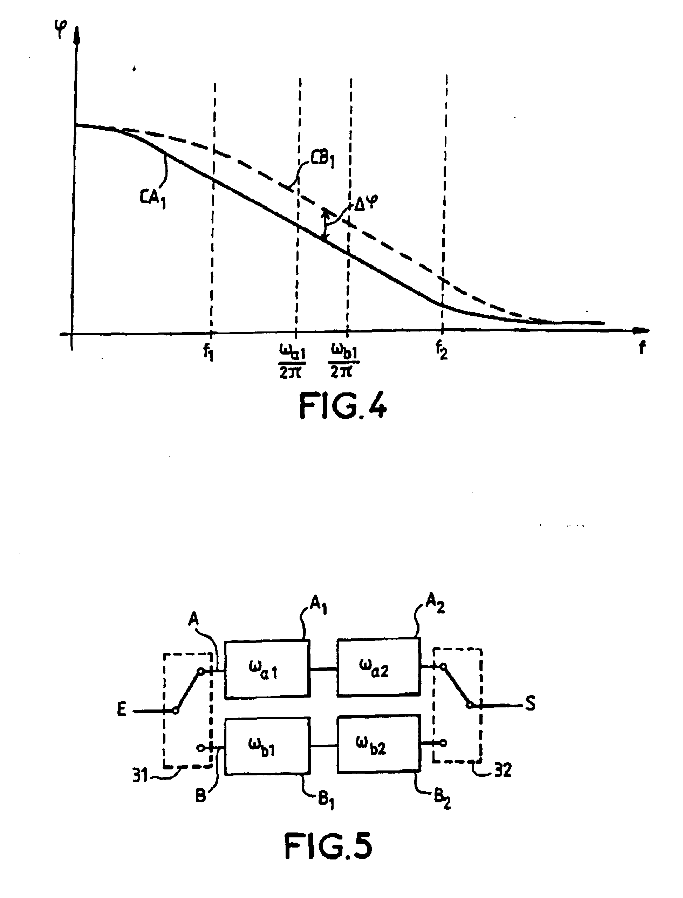

La figure 4 présente deux courbes de déphasages $CA_1$ et $CB_1$ correspondant respectivement à la cellule $A_1$ de la première voie, appelée par la suite voie A, et à la cellule $B_1$ de la deuxième voie, appelée par la suite voie B. Les deux courbes sont décalées et parallèles sur une bande de fréquences $[f_1, f_2]$. La différence entre ces deux courbes est obtenue en jouant sur les paramètres des cellules $A_1$, $B_1$, notamment sur les valeurs des capacités $C_1$, $C_2$ et des inductances $L_1$, $L_2$ de chaque cellule. Le décalage Δφ entre ces deux courbes est le déphasage appliqué à un signal entrant lorsqu'il est commuté d'une voie à l'autre. Ce décalage Δφ représente le déphasage entre les deux voies A et B. Le déphasage Δφ d'un signal est donc obtenu en le commutant d'une voie à l'autre, par exemple de la voie B à la voie A. Arbitrairement, la voie B peut par exemple être prise pour référence, c'est-à-dire correspondant à un déphasage différentiel nul.

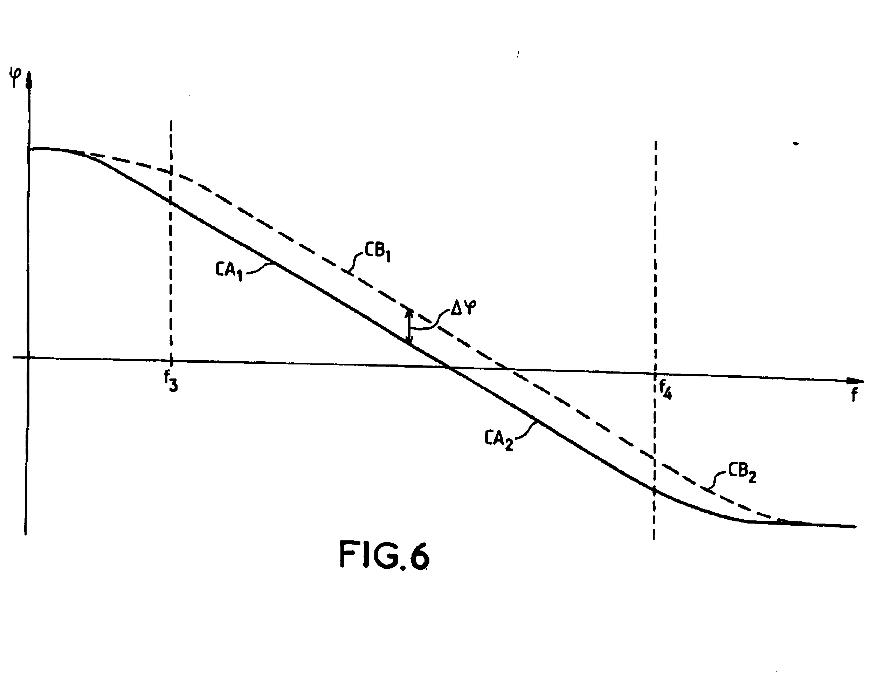

La figure 5 illustre par un schéma synoptique un deuxième exemple de déphaseur selon l'invention. Ce déphaseur est toujours composé de cellules « passe-tout » réparties sur deux voies en parallèle. Chaque voie comporte en série n cellules du type de celle de la figure 1, deux dans le cas de la figure 5. Le déphaseur comporte donc dans ce cas quatre cellules $A_1$, $A_2$, $B_1$, $B_2$ ayant des pulsations de transition notées respectivement $\omega_{a1}$, $\omega_{a2}$, $\omega_{b1}$, $\omega_{b2}$. Comme dans l'exemple précédent, un premier commutateur 31 aiguille le signal d'entrée E sur l'une ou l'autre voie. Un deuxième commutateur 32, ou commutateur de sortie, aiguille la voie véhiculant le signal sur la sortie S du déphaseur, ces commutateurs 31, 32 pouvant être actifs ou passifs.

La figure 6 représente le cas où l'on prend en compte la totalité des quatre cellules $A_1$, $A_2$, $B_1$, $B_2$ du déphaseur. Les deuxièmes cellules $A_2$, $B_2$ des voies A et B permettent d'augmenter la bande de fonctionnement du déphaseur. En particulier, les paramètres de la cellule $A_2$ sont définis de sorte que la courbe de déphasage correspondante $CA_2$ prolonge la courbe de déphasage $CA_1$ de la première cellule $A_1$. De même, sur la voie B, les paramètres de la cellule $B_2$ sont définis de sorte que la courbe de déphasage correspondante $CB_2$ prolonge la courbe de déphasage $CB_1$ de la première

cellule $B_1$. En réalité, chaque cellule agit néanmoins sur toute la bande de fréquence.

Le déphaseur à quatre cellules $A_1$, $A_2$, $B_1$, $B_2$ fonctionne alors sur une bande de fréquences $[f_3, f_4]$, où $f_3 < f_1$ et $f_4 > f_2$, $f_1$ et $f_2$ étant les fréquences bornant la bande $[f_1, f_2]$ définie précédemment relativement à la figure 4. On élargit ainsi cette bande, de part et d'autre.

Le déphasage $\Delta\varphi$ entre les deux voies est donné par la relation suivante :

$$\Delta\varphi = 4 \left[ arctg(\frac{pq}{k} - \frac{1}{kpq}) + arctg(\frac{p}{kq} - \frac{q}{kp}) \right] \qquad (3)$$

avec

$$p^2 = \frac{\omega_{a1}}{\omega_{b1}} = \frac{\omega_{a2}}{\omega_{b2}} \qquad \text{et} \qquad q^2 = \frac{\omega_{a2}}{\omega_{a1}} = \frac{\omega_{b2}}{\omega_{b1}}$$

et $k = \sqrt{\dfrac{1-m}{1+m}}$ où m est la valeur de mutuelle inductance relative telle que définie précédemment par la relation (1), m est comprise entre 0 et 1.

L'équation donnée par la relation (3) n'étant pas directement soluble, on peut par exemple utiliser un programme de calcul pour déterminer les éléments théoriques p et q pour obtenir un déphasage $\Delta\varphi$ et un coefficient de mutuelle inductance m donnés. On en déduit alors les fréquences ou pulsation de transition $\omega_{a1}$, $\omega_{a2}$, $\omega_{b1}$, $\omega_{b2}$ de chacune des cellules et donc les valeurs de leurs paramètres ou composants $L_1$, $L_2$, $C_1$, $C_2$. La relation (3) montre que le déphasage $\Delta\varphi$ dépend notamment du paramètre k et donc de la valeur m de la mutuelle inductance. Ce déphasage $\Delta\varphi$ dépend aussi de la fréquence du signal auquel il s'applique. Il est possible d'augmenter encore la bande $[f_3, f_4]$ avec n > 2. Dans ce cas, les équations deviennent cependant plus compliquées.

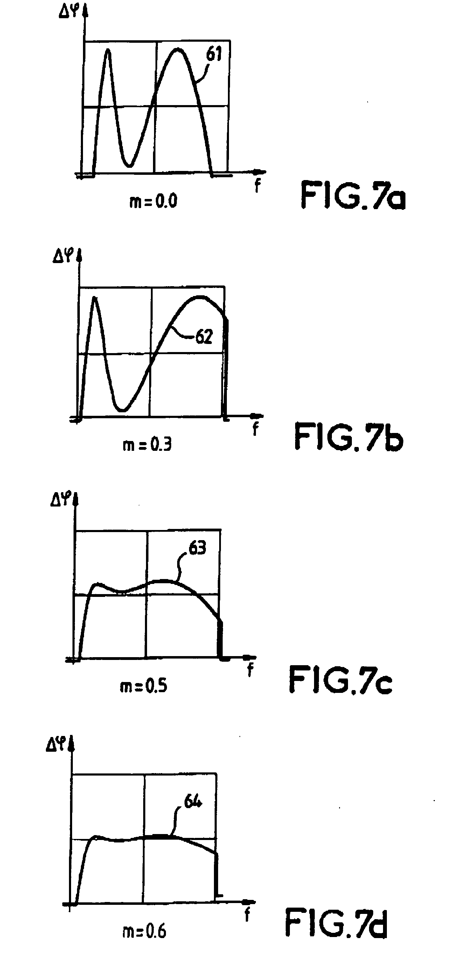

Les figures 7a à 7d montrent l'allure de ce déphasage $\Delta\varphi$ en fonction de la fréquence pour certaines valeurs de mutuelle inductance relatives m, et pour des paramètres $L_1$, $L_2$, $C_1$, $C_2$ idéaux sensés données des courbes de déphasages $CA_1$, $CA_2$, $CB_1$, $CB_2$ telles qu'illustrées par la figure 6. A titre d'exemple, en se référant à la relation (1),

$m = \dfrac{M}{L_1}$, c'est-à-dire que $L_1 = L_2$. Ces courbes sont sensiblement parallèles et donc le déphasage est sensiblement constant. Ces figures 7a à 7d mises en évidence par la Déposante vont montrer l'influence combinée de la fréquence et de la mutuelle inductance m sur les fluctuations du déphasage $\Delta\varphi$.

En particulier, les figures 7a, 7b, 7c et 7d, tracées avec une échelle commune et pour n = 2, correspondent aux cas où m est égal respectivement à 0,0 ; 0, 3 ; 0,5 et 0,6. Dans le cas où m = 0, l'allure du déphasage en fonction de la fréquence est représentée par une courbe 61 très fluctuante, ce qui traduit un déphasage $\Delta\varphi$ qui varie de même en fonction de la fréquence. Plus la valeur m de mutuelle inductance augmente, moins les fluctuations des courbes 62, 63, 64 apparaissent. Plus particulièrement, pour m=0,6 par exemple, la courbe 64 représentative du déphasage $\Delta\varphi$ reste sensiblement constante sur une relativement large bande de fréquences, ce qui correspond à un meilleur parallélisme des courbes $CA_1$, $CA_2$ et $CB_1$, $CB_2$ sur cette bande de fréquences. Les figures 6a à 6d montrent l'intérêt d'obtenir une valeur m de mutuelle inductance relative la plus grande possible. La valeur m = 0,6 est approximativement la valeur maximale que l'on peut obtenir en pratique en utilisant la technique des spirales imbriquées. On peut imaginer une amélioration par une valeur m > 0,6 en utilisant par exemple des spirales superposées avec plusieurs niveaux métalliques.

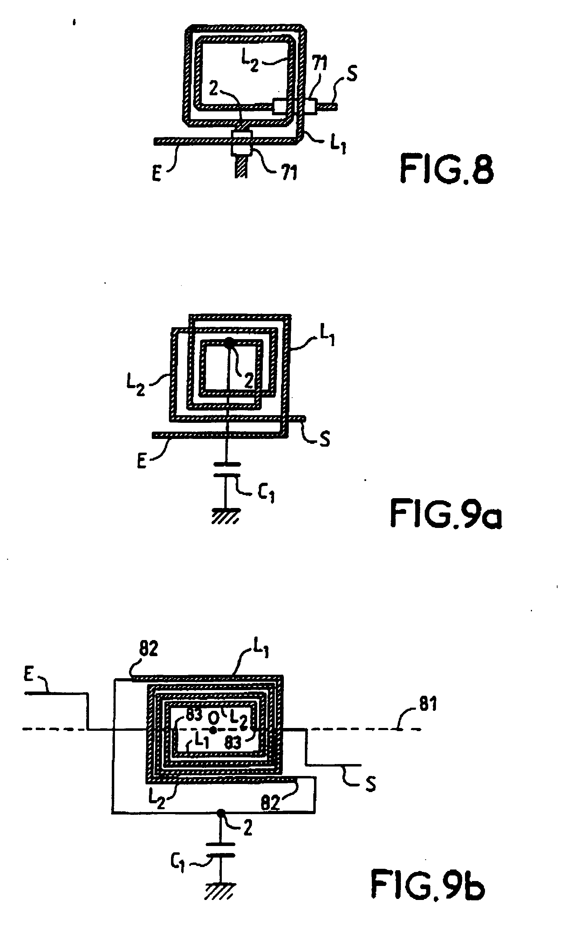

La figure 8 présente un exemple de réalisation possible des deux inductances $L_1$, $L_2$ d'une cellule passe-tout 1 qui permet d'obtenir une mutuelle inductance m entre ces deux inductances relativement élevée, grâce à un couplage élevé entre ces deux inductances $L_1$, $L_2$. Il s'agit de spirales imbriquées. Une première spirale formée entre l'entrée E et le point milieu 2 constitue la première inductance $L_1$ et une deuxième spirale formée entre ce point milieu 2 et la sortie S, imbriquée dans la première spire, constitue la deuxième inductance $L_2$. Ces spirales sont par exemple des pistes conductrices réalisées sur un substrat. Ces pistes peuvent être en or et le substrat en Arséniure de Gallium (AsGa). Dans le cas de la figure 8, les spirales sont par exemple formées d'une spire chacune. Les spires peuvent être circulaires ou carrées. Du fait que les spirales sont imbriquées, les pistes peuvent se croiser. Des moyens d'isolation 71 sont alors disposés entre les parties de piste qui se chevauchent.

Les figures 9a et 9b présentent d'autres exemples de réalisations possibles des inductances $L_1$, $L_2$, toujours formées par exemples de pistes en spirales réalisées sur un substrat. Dans le cas de la figure 9a, les spirales sont toujours imbriquées, mais l'une n'est plus contenue dans l'autre. Elles sont décalées. Cela permet notamment d'obtenir un bon couplage entre les inductances, donc une valeur m relativement élevée, tout en conservant aux deux spirales des longueurs identiques et donc des valeurs d'inductance $L_1$, $L_2$ sensiblement identiques. La figure 9b présente un autre mode de réalisation qui permet d'obtenir un bon couplage et des valeurs d'inductances identiques. Les deux spirales $L_1$, $L_2$ sont imbriquées l'une dans l'autre et disposées symétriquement par rapport à un axe 81. Elles sont même par exemple symétrique par rapport à un point O situé sur cet axe 81. Chaque spirale $L_1$, $L_2$ a une extrémité intérieure 83 à l'ensemble des deux spirales, et une extrémité extérieure 82. Les extrémités extérieures 82 sont reliées au point milieu 2 lui-même relié au condensateur $C_1$. L'extrémité intérieure 83 de la première spirale $L_1$ est reliée à l'entrée E et l'extrémité intérieure 83 de la deuxième spirale $L_2$ est reliée à la sortie S.

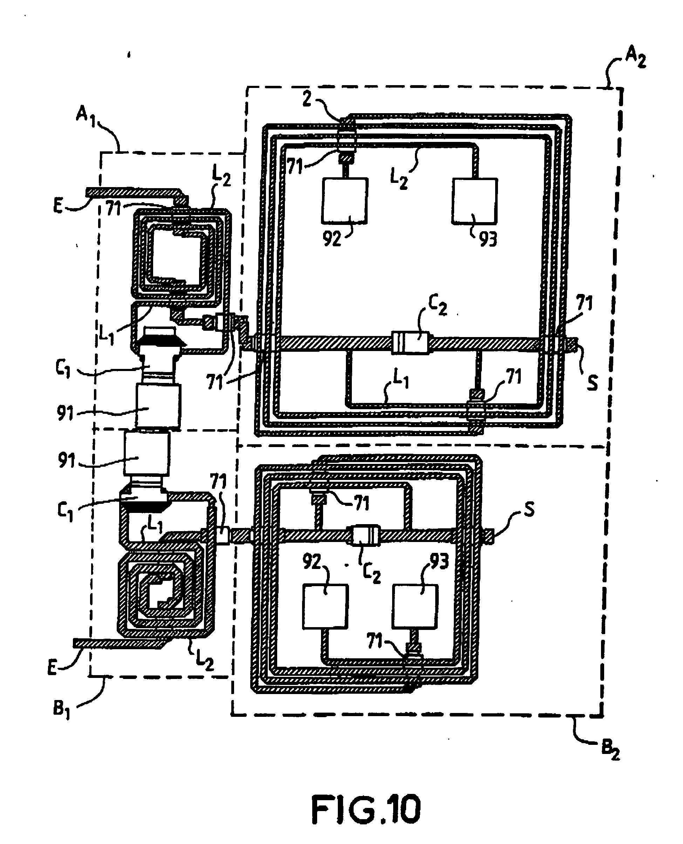

La figure 10 présente un exemple de réalisation possible d'un déphaseur selon l'invention, conformément au schéma synoptique de la figure 5 comportant deux voies de deux cellules passe-tout, les commutateurs 31, 32 n'étant pas représentés. Ce déphaseur comporte quatre cellules passe-tout $A_1$, $A_2$, $B_1$, $B_2$ dont les inductances sont réalisées à partir de spirales du type par exemple des figures 8, 9a et 9b. Chaque cellule $A_1$, $A_2$, $B_1$, $B_2$ comporte donc au moins deux inductances $L_1$, $L_2$ en spirales imbriquées. Pour des raisons de facilité de lecture, La première inductance est notée $L_1$ dans chaque cellule, bien que sa valeur et sa forme puisse être différente d'une cellule à l'autre. Il en est de même pour la deuxième inductance $L_2$ ainsi que pour les condensateurs de masse $C_1$ et les condensateurs de pont $C_2$.

Les cellules $A_1$ et $B_1$ comportent chacune deux inductances $L_1$, $L_2$ réalisées par exemples selon le modèle de la figure 7. La première inductance $L_1$ est reliée à l'entrée E de la cellule $A_1$, $B_1$. Le condensateur $C_1$, relié au point de jonction des inductances $L_1$, $L_2$ est reliée par ailleurs au potentiel de masse par un trou métallisé 91. Il n'y a pas de condensateur de pont $C_2$ reliant l'entrée à la sortie de la cellule. En particulier, les capacités parasites suffisent à produire une capacité de valeur minimum. Pour créer un déphasage $\Delta\varphi$ entre les deux cellules $A_1$, $B_1$, on joue sur les paramètres définissant les inductances et la capacité $C_1$. Ce peut être par exemple la longueur des spirales ou la largeur des pistes pour définir les inductances, et classiquement les dimensions du condensateur $C_1$ pour sa capacité.

Les cellules $A_2$, $B_2$ ont une structure analogue, mais avec des valeurs d'inductances et de capacités très différentes, et donc avec des paramètres géométriques très différents. En particulier, les valeurs des inductances $L_1$, $L_2$ sont plus grandes que celles des cellules $A_1$, $B_1$. A cet effet, leurs spires sont plus grandes. Pour ces cellules $A_2$, $B_2$ il y a un condensateur de pont $C_2$, reliant l'entrée à la sortie de la cellule, mais pas de condensateur $C_1$ reliant le point de jonction 2 des inductances à la masse, ce qui correspond à une valeur de capacité infinie. Chaque inductance $L_1$, $L_2$ a donc une extrémité reliée directement à la masse par l'intermédiaire par exemple d'un trou métallisé 92, 93, l'une $L_1$ ayant son autre extrémité reliée à l'entrée de la cellule et l'autre $L_2$ ayant son autre extrémité reliée à la sortie de la cellule. Cette dernière est reliée à l'entrée du commutateur de sortie 32. Comme pour les cellules $A_1$, $B_1$, on joue par exemple sur les paramètres géométriques définissant les inductances et les capacités pour assurer un déphasage $\Delta\phi$ donné, qui est approximativement de préférence le même que celui qui existe entre ces cellules $A_1$, $B_1$. Les courbes de déphasage $CA_2$, $CB_2$ correspondant aux cellules $A_2$, $B_2$ prolongent les courbes de déphasage $CA_1$, $CB_1$ correspondant aux cellules $A_1$, $B_1$. Dans l'exemple de réalisation de la figure 10, les inductances $L_1$, $L_2$ des cellules $A_1$, $B_1$ sont plus faibles que les inductances $L_1$, $L_2$ des cellules $A_2$, $B_2$. Il en résulte que les fréquences de transition, ou pulsations de transition $\omega_{a1}$, $\omega_{b1}$, des cellules $A_1$, $B_1$ sont plus grandes que les pulsations de transition $\omega_{a2}$, $\omega_{b2}$ des cellules $A_2$, $B_2$. Les courbes $CA_1$, $CB_1$ se situent donc dans la bande de haute fréquence et les courbes $CA_2$, $CB_2$ se situent donc dans une bande de fréquences plus basses, de façon à couvrir bien sûr une large bande $[f_3, f_4]$ continue. En d'autres termes et en première approximation, les cellules $A_1$, $B_1$ déphasent les signaux à hautes fréquences et les cellules $A_2$, $B_2$ déphasent les signaux à basses fréquences. Pour des raisons de simplicité de mise en oeuvre notamment, le condensateur $C_2$ n'est pas réalisé dans les cellules $A_1$, $B_1$ et le condensateur $C_1$ n'est pas réalisé dans les cellules $A_2$, $B_2$. Cela correspond à un exemple de mode de réalisation, il est bien sûr possible de réaliser les deux condensateurs $C_1$, $C_2$ dans ces cellules.

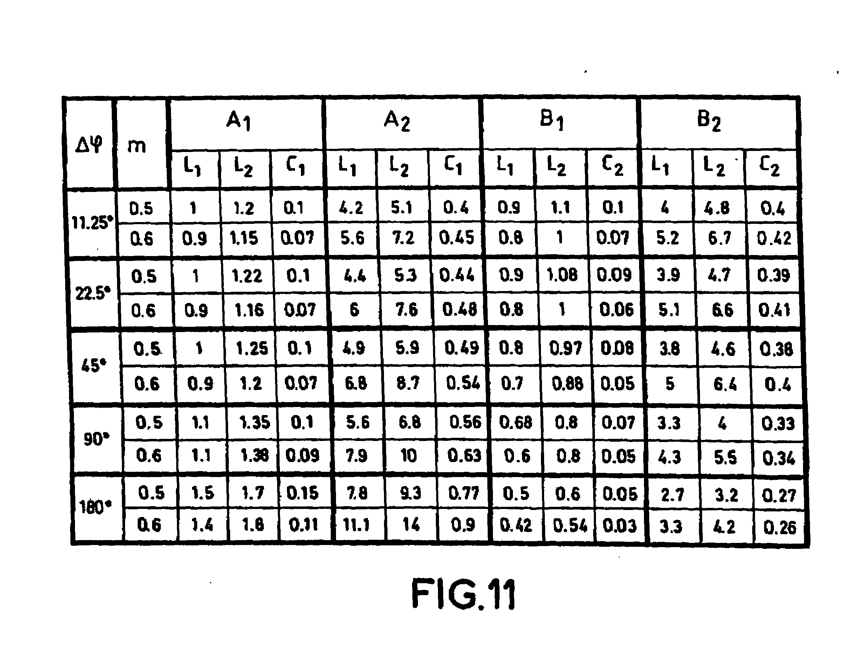

La figure 11 présente à titre d'exemple un tableau indiquant plusieurs valeurs de déphasage $\Delta\phi$ en fonction des valeurs des composants $L_1$, $L_2$, $C_1$, $C_2$ des cellules de la figure 9, et en fonction de la valeur de mutuelle relative m résultant de l'imbrication des inductances et pour une bande de fréquences donnée dans le domaine des micro-ondes. En effet, en jouant sur les paramètres des cellules, c'est-à-dire essentiellement sur les paramètres géométriques de leurs composants $L_1$, $L_2$, $C_1$, $C_2$ on peut obtenir différentes valeurs de déphasages. Les valeurs des inductances $L_1$, $L_2$ et des capacités $C_1$, $C_2$ sont données en valeurs relatives. Conformément à ce qui a été décrit relativement à la figure 10, il apparaît que les valeurs des inductances $L_1$, $L_2$ des cellules $A_1$, $B_1$ sont nettement inférieures à celles des cellules $A_2$, $B_2$. Un déphaseur du type de la figure 10, une fois réalisé, permet d'obtenir une seule valeur de déphasage $\Delta\varphi$. C'est un déphaseur élémentaire à un bit de commande. Les valeurs de déphasage $\Delta\varphi$ données à titre d'exemple sont 11,25° ; 22,5° ; 45° ; 90° et 180°.

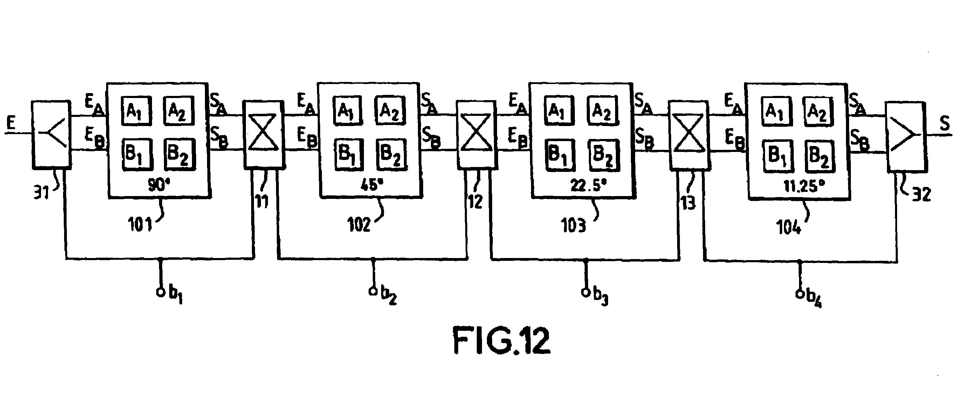

La figure 12 présente un autre exemple de réalisation d'un déphaseur selon l'invention. Il s'agit d'un déphaseur à quatre bits. Plus particulièrement, il comporte quatre déphaseurs élémentaires 101, 102, 103, 104 en série, c'est-à-dire en cascade, du type de celui de la figure 10. Un premier déphaseur 101 crée un déphasage de 90°, les déphaseurs suivant 102, 103, 104 créent les déphasages respectifs 45°, 22,5° et 11,25°. Un commutateur 11, 12, 13 est placé entre deux déphaseurs élémentaires successifs. Ces commutateurs sont des commutateurs « 2 vers 2 », c'est-à-dire que leur règle de commutation est la suivante, en notant $E_A$, $E_B$ et $S_A$, $S_B$ les entrées et sorties respectives des voies A et B d'un déphaseur élémentaire :

1er état: La sortie $S_A$ d'un déphaseur est aiguillée vers l'entrée $E_A$ du déphaseur suivant ;
2éme état : La sortie sortie $S_B$ d'un déphaseur est aiguillée vers l'entrée $E_B$ du déphaseur suivant ;
3ème état : La sortie $S_A$ d'un déphaseur est aiguillée vers l'entrée $E_B$ du déphaseur suivant ;
4ème état : La sortie $S_B$ d'un déphaseur est aiguillée vers l'entrée $E_A$ du déphaseur suivant.

Les états d'un tel commutateur sont donc commandés par deux bits.

Le commutateur 31 qui relie l'entrée E du déphaseur aux entrées $E_A$, $E_B$ du premier déphaseur élémentaire 101 est un commutateur « 1 vers 2 » du type de celui de la figure 3. Le commutateur 32 qui relie les sorties $S_A$, $S_B$ du dernier déphaseur élémentaire de la chaîne à la sortie S du déphaseur complet est un commutateur « 2 vers 1 » du type de celui de la figure 3. Selon que le signal est présent sur l'une ou l'autre sortie $S_A$, $S_B$, ce commutateur relie la sortie S à la voie sur laquelle le signal est présent. A ce titre, ce dernier commutateur 32 est en fait commandé par l'état du dernier commutateur « 2 vers 2 » 13. Il en est de même des états des autres commutateurs qui dépendent des états des commutateurs précédents. Les commutateurs d'entrée 31 et de sortie 32 sont commandés par un seul bit. Les bits de commande $b_1$, $b_2$, $b_3$, $b_4$ du circuit de la figure 12 sont donc reliés aux commutateurs de la façon suivante :

Le premier bit $b_1$ commande le commutateur d'entrée 31 et le commutateur suivant 11 ;
Le deuxième bit $b_2$ commande ce commutateur 11 et le commutateur suivant 12 ;
Le troisième bit $b_3$ commande ce commutateur 12 et le commutateur suivant 13 ;
Le quatrième bit $b_4$ commande ce commutateur 13 et le commutateur de sortie 32 ;

Dans cette configuration, les commutateurs d'entrée et de sortie 31, 32 sont bien commandés par un bit et les commutateurs intermédiaires 11, 12, 13 sont bien commandés par deux bits.

Un déphaseur selon la figure 12, permet de réaliser tous les déphasages $\Delta\varphi$ compris entre 0° et 168,75° inclus par pas de 11,25°. A titre d'exemple, on peut prendre comme état de référence le cas où le signal passe par toutes les voies B des déphaseurs élémentaires. Le déphasage relatif par rapport à cette référence sera $\Delta\varphi$ = 168,75° si le signal passe par toutes les voies A. A titre d'exemple pour un codage 0000 le déphasage $\Delta\phi$ est 0°. Dans ce dernier cas la valeur maximum 168,75° est logiquement obtenue pour le codage 1111. Le déphaseur de la figure 12 comporte quatre déphaseurs élémentaires, il est bien sûr possible d'envisager un déphaseur comportant un nombre différent de déphaseurs élémentaires. Si ce dispositif de déphasage comporte N déphaseurs élémentaires, le déphasage $\Delta\varphi$ d'un déphaseur élémentaire au suivant croît ou décroît par exemple d'un pas $\phi/2^N$, $\phi$ étant un déphasage maximum de référence, par exemple 180°.

Avantageusement, les commutateurs sont par exemple alternativement actif et passif. La séquence des composants de la chaîne d'un déphaseur du type de celui de la figure 12 peut donc être la suivante :

- un commutateur 31 actif ;
- un déphaseur 101 de 90° ;
- un commutateur 11 passif ;
- un déphaseur 102 de 45° ;
- un commutateur 12 actif ;
- un déphaseur 103 de 22,5° ;
- un commutateur 13 passif ;
- un déphaseur 104 de 11,25° ;
- un commutateur 32 actif.

Cette solution d'alternance permet notamment d'atteindre un bon compromis entre les performances de l'ensemble de la chaîne et la taille ou surface occupée par cet ensemble. La figure 12 illustre ce propos.

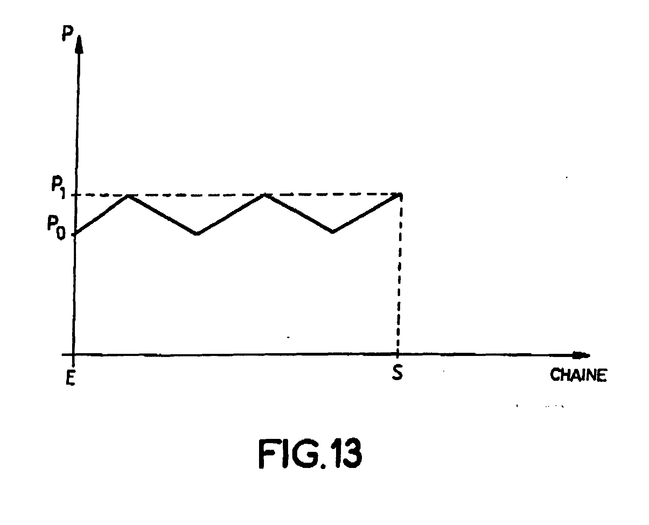

La figure 13 montre une courbe 121 représentative de la puissance véhiculée par un signal au fur et à mesure qu'il avance dans la chaîne de composants constituant le déphaseur de la figure 12, dans le cas d'un exemple de réalisation où les commutateurs sont alternativement actifs et passifs. L'emploi d'un commutateur actif a notamment comme avantage de bloquer les ondes stationnaires qui pourraient perturber le fonctionnement du déphaseur, car le paramètre $S_{12}$ (retour du signal de la sortie vers l'entrée) est très faible par rapport à $S_{21}$. En particulier, si le commutateur est passif, et donc symétrique, il peut perturber la fonction de déphasage dans la mesure où il induit alors des signaux d'erreur dus aux fuites. Il est donc préférable d'utiliser des commutateurs actifs. Les commutateurs actifs ont néanmoins un inconvénient, cet inconvénient est qu'ils amplifient de façon inhérente un signal qui les traverse. A l'issue du passage du signal dans plusieurs commutateurs actifs, ce dernier est alors fortement amplifié. Il faut alors prévoir un dimensionnement des composants, des commutateurs eux-mêmes mais aussi des déphaseurs élémentaires, qui supportent cette augmentation de puissance ainsi produite. Une conséquence directe de dimensionnement est notamment l'augmentation de surface occupée par ces composants, et une augmentation de la consommation en énergie, ce qui va à l'encontre de l'objectif de réduction de l'encombrement des déphaseurs, mais aussi de réduction de coût et bien sûr de consommation. La solution d'alternance illustrée par la figure 13 permet de répondre à cet objectif. A partir de l'entrée E du déphaseur où un signal comporte une puissance initiale $P_0$, sa puissance augmente dans le premier commutateur 31, qui est actif, jusqu'à une puissance $P_1$. Sa puissance diminue ensuite dans le deuxième commutateur 11 et dans les structures de déphasage, qui est passif, puis augmente de nouveau dans le commutateur actif suivant 12 et ainsi de suite. Il en résulte que tout au long de la chaîne et jusqu'à la sortie, la puissance qui traverse les différents composants est sensiblement constante, permettant de réaliser un bon compromis entre la consommation électrique, le facteur de bruit, la linéarité de la chaîne et l'encombrement. Cette puissance n'excède pas ou peu la puissance $P_1$, et reste donc en deçà d'une limite admissible. L'alternance illustrée par la figure 13 est une alternance actif - passif - actif, il serait bien sûr possible de réaliser une alternance passif - actif - passif en plaçant un commutateur passif 31 en entrée du déphaseur. Néanmoins, pour des raisons d'adaptation et de facteur de bruit, il peut être préférable de commencer par un commutateur actif 31. Toute autre disposition que l'alternance stricte reste cependant possible.

Les exemples de réalisation présentés précédemment comportent des déphaseurs élémentaires où chaque voie A, B comporte deux cellules « passe-tout » 1, il est bien sûr possible d'envisager des voies comportant plus de deux cellules, dans le but d'élargir encore la bande de fréquences.

## Revendications

1. Dispositif de déphasage d'un signal, comportant au moins un commutateur (31) et un déphaseur élémentaire ($A_1$, $A_2$, $B_1$, $B_2$) ayant deux voies parallèles (A, B) comprenant chacune n cellules (1), le commutateur (31) aiguillant le signal d'entrée (E) vers l'une ou l'autre des voies, chaque cellule (1) déphasant un signal selon une loi ($CA_1$, $CA_2$, $CB_1$, $CB_2$) fonction de la fréquence du signal d'entrée de la cellule, le déphasage $\Delta\varphi$ produit par un déphaseur élémentaire étant le déphsage entre le signal de sortie de la première des deux voies (A) et le signal de sortie de la deuxième des deux voies (B) et étant obtenu en commutant le signal d'entrée du déphaseur élémentaire d'une voie à l'autre, les composants ($L_1$, $L_2$, $C_1$, $C_2$) des cellules (1) étant définis de sorte que la courbe représentative ($CA_1$, $CA_2$) de la loi de déphasage de la première voie (A) par rapport à la fréquence soit parallèle à la courbe représentative ($CB_1$, $CB_2$) de la loi de déphasage de la deuxième voie (B) par rapport à la fréquence dans une bande de fréquences, **caractérisé en ce que**, les cellules (1) étant des cellules passe-tout, les composants ($L_1$, $L_2$, $C_1$, $C_2$) des cellules (1) sont définis de sorte que dans une voie (A, B) les courbes représentatives du déphasage des cellules par rapport à la fréquence ($CA_1$, $CA_2$ et $CB_1$, $CB_2$) se prolongent chaque cellule contribuant à élargir ladite bande de fréquence.

2. Dispositif selon la revendication 1, **caractérisé en ce qu'**il comporte plusieurs déphaseurs élémentaires (101, 102, 103, 104) en cascade.

3. Dispositif selon la revendication 2, **caractérisé en ce que** les déphaseurs élémentaires (101, 102, 103, 104) sont reliés entre eux par des commutateurs (11, 12, 13).

4. Dispositif selon la revendication 3, **caractérisé en ce que** les commutateurs (11, 12, 13) sont des commutateurs « 2 vers 2 » à quatre états

5. Dispositif selon l'une quelconque des revendications 2 à 4, **caractérisé en ce que** le déphasage $\Delta\varphi$ d'un déphaseur élémentaire au suivant varie d'un pas $\varphi/2^N$, $\varphi$ étant un déphasage de référence

6. Dispositif selon l'une quelconque des revendications 3 à 5, **caractérisé en ce que** les commutateurs (31, 11, 12, 13, 32) sont alternativement actifs et passifs.

7. Dispositif selon l'une quelconque des revendications précédentes, **caractérisé en ce que** le premier commutateur (31) commutant l'entrée (E) sur le premier déphaseur élémentaire (101) est actif.

**8.** Dispositif selon l'une quelconque des revendications précédentes, **caractérisé en ce qu'**un déphaseur élémentaire comporte quatre cellules, deux cellules $A_1$, $A_2$ dans la première voie (A) et deux cellules $B_1$, $B_2$ dans la deuxième voie (B) :

    - les cellules $A_1$, $B_1$, comportant un condensateur de masse ($C_1$), relié au point de jonction des inductances, relié par ailleurs au potentiel de masse par un trou métallisé (91) ;
    - les cellules $A_2$, $B_2$, ayant un condensateur de pont ($C_2$) reliant l'entrée à la sortie de la cellule, chaque inductance ($L_1$, $L_2$) étant reliée à un condensateur ($C_1$) relié par ailleurs à la masse, une inductance ($L_1$) ayant son autre extrémité reliée à l'entrée de la cellule et l'autre inductance ($L_2$) ayant son autre extrémité reliée à la sortie de la cellule.

**9.** Dispositif selon la revendication 8, **caractérisé en ce que** les cellules $A_1$, $B_1$ ont un condensateur de pont ($C_2$) réduit à zéro.

**10.** Dispositif selon l'une quelconque des revendications 8 ou 9, **caractérisé en ce que** les cellules $A_2$, $B_2$ ont un condensateur de masse ($C_1$) réduit à un court-circuit.

**11.** Dispositif selon l'une quelconque des revendications 8 à 10, **caractérisé en ce que** le condensateur ($C_1$) des cellules $A_1$, $B_1$ est relié au potentiel de masse par un trou métallisé (91).

**12.** Dispositif selon l'une quelconque des revendications 8 à 11, **caractérisé en ce que** les inductances sont reliées au potentiel masse par l'intermédiaire de trous métallisés (92, 93).

**13.** Dispositif selon l'une quelconque des revendications précédentes, **caractérisé en ce que** les inductances ($L_1$, $L_2$) des cellules (1) sont des spirales imbriquées.

**14.** Dispositif selon l'une quelconque des revendications 1 à 12, **caractérisé en ce que** les inductances sont des spirales superposées avec plusieurs niveaux métalliques.

**15.** Dispositif selon l'une quelconque des revendications 13 ou 14, **caractérisé en ce que** la spirale formant une inductance ($L_2$) est contenue dans la spirale formant l'autre inductance ($L_1$).

**16.** Dispositif selon l'une quelconque des revendications 13 ou 14, **caractérisé en ce que** les spirales sont décalées.

**17.** Dispositif selon l'une quelconque des revendications 13 à 16, **caractérisé en ce que** les spirales sont symétriques par rapport à un axe (81).

**18.** Dispositif selon l'une quelconque des revendications 13 à 17, **caractérisé en ce que** les spirales sont des pistes conductrices réalisées sur un substrat.

**19.** Dispositif selon la revendication 18, **caractérisé en ce que** le substrat est en Arséniure de Gallium (AsGa).

**20.** Dispositif selon l'une quelconque des revendications 18 ou 19, **caractérisé en ce que** les pistes sont en or.

**Claims**

**1.** Device for the phase-shifting of a signal, comprising at least a selector switch (31) and an elementary phase shifter ($A_1$, $A_2$, $B_1$, $B_2$) having two parallel channels (A, B) each comprising n cells (1), the selector switch (31) routing the input signal (E) towards one or other of the channels, each cell (1) phase-shifting a signal according to a law ($CA_1$, $CA_2$, $CB_1$, $CB_2$) that is a function of the frequency of the input signal of the cell, the phase-shift $\Delta\phi$ produced by an elementary phase shifter being the phase shift between the output signal of the first of the two channels (A) and the output signal of the second of the two channels (B) and being obtained by switching the input signal of the elementary phase shifter from one channel to the other, the components ($L_1$, $L_2$, $C_1$, $C_2$) of the cells (1) being defined so that the curve ($CA_1$, $CA_2$) representative of the phase-shift law of the first channel (A) with respect to the frequency is parallel to the curve ($CB_1$, $CB_2$) representative of the phase-shift law of the second channel (B) with respect to the frequency in a frequency band, **characterized in that**, since the cells (1) are all-pass cells, the components ($L_1$, $L_2$, $C_1$, $C_2$) of the cells (1) are defined so that, in a channel (A, B), the representative curves ($CA_1$, $CA_2$ and $CB_1$,

$CB_2$) of the phase shift of the cells with respect to the frequency prolong one another, each cell contributing to broaden said frequency band.

2. Device according to Claim 1, **characterized in that** it comprises several elementary phase shifters (101, 102, 103, 104) in cascade.

3. Device according to Claim 2, **characterized in that** the elementary phase shifters (101, 102, 103, 104) are connected to one another by selector switches (11, 12, 13).

4. Device according to Claim 3, **characterized in that** the selector switches (11, 12, 13) are four-state 2-to-2 selector switches.

5. Device according to any one of Claims 2 to 4, **characterized in that** the phase shift $\Delta\phi$ from one elementary phase shifter to the next varies by a step $\phi/2^N$, $\phi$ being a reference phase shift.

6. Device according to any one of Claims 3 to 5, **characterized in that** the selector switches (31, 11, 12, 13, 32) are alternately active and passive.

7. Device according to any one of the preceding claims, **characterized in that** the first selector switch (31) switching the input (E) to the first elementary phase shifter (101) is active.

8. Device according to any one of the preceding claims, **characterized in that** an elementary phase shifter comprises four cells, two cells $A_1$, $A_2$ in the first channel (A) and two cells $B_1$, $B_2$ in the second channel (B):

   - the cells $A_1$, $B_1$, comprising a ground capacitor ($C_1$), connected to the junction point of the inductors, and furthermore connected to ground potential via a plated hole (91);
   - the cells $A_2$, $B_2$ having a bridge capacitor ($C_2$) connecting the input to the output of the cell, each inductor ($L_1$, $L_2$) being connected to a capacitor ($C_1$) furthermore connected to ground, one inductor ($L_1$) having its other end connected to the input of the cell and the other inductor ($L_2$) having its other end connected to the output of the cell.

9. Device according to Claim 8, **characterized in that** the cells $A_1$, $B_1$ have a bridge capacitor ($C_2$) reduced to zero.

10. Device according to either of Claims 8 and 9, **characterized in that** the cells $A_2$, $B_2$ have a ground capacitor ($C_1$) reduced to a short circuit.

11. Device according to any one of Claims 8 to 10, **characterized in that** the capacitor ($C_1$) of the cells $A_1$, $B_1$ is connected to ground potential via a plated hole (91).

12. Device according to any one of Claims 8 to 11, **characterized in that** the inductors are connected to ground potential via means of plated holes (92, 93).

13. Device according to any one of the above claims, **characterized in that** the inductors ($L_1$, $L_2$) of the cells (1) are imbricated spirals.

14. Device according to any one of Claims 1 to 12, **characterized in that** the inductors are spirals superimposed with several metal levels.

15. Device according to either of Claims 13 and 14, **characterized in that** the spiral forming an inductor ($L_2$) is contained in the spiral forming the other inductor ($L_1$).

16. Device according to either of Claims 13 and 14, **characterized in that** the spirals are offset.

17. Device according to any one of Claims 13 to 16, **characterized in that** the spirals are symmetrical with respect to an axis (81).

18. Device according to any one of Claims 13 to 17, **characterized in that** the spirals are conductive tracks made on a substrate.

**19.** Device according to Claim 18, **characterized in that** the substrate is made of gallium arsenide (GaAs).

**20.** Device according to either of Claims 18 and 19, **characterized in that** the tracks are made of gold.

**Patentansprüche**

**1.** Vorrichtung zum Phasenverschieben eines Signals, die mindestens einen Umschalter (31) und einen elementaren Phasenregler ($A_1$, $A_2$, $B_1$, $B_2$) aufweist, der zwei parallele Kanäle (A, B) hat, die jeweils n Zellen (1) aufweisen, wobei der Umschalter (31) das Eingangssignal (E) zu dem einem oder dem anderen der Kanäle lenkt, wobei jede Zelle (1) ein Signal gemäß einem Gesetz ($CA_1$, $CA_2$, $CB_1$, $CB_2$), das von der Frequenz des Eingangssignals der Zelle abhängt, phasenverschiebt, wobei die Phasenverschiebung $\Delta\varphi$, die von einem elementaren Phasenregler erzeugt wird, die Phasenverschiebung zwischen dem Ausgangssignal des ersten der zwei Kanäle (A) und dem Ausgangssignal des zweiten der zwei Kanäle (B) ist und erzielt wird, indem das Eingangssignal des elementaren Phasenreglers von dem einen zu dem anderen Kanal umgeschaltet wird, wobei die Komponenten ($L_1$, $L_2$, $C_1$, $C_2$) der Zellen (1) so definiert sind, dass die repräsentative Kurve ($CA_1$, $CA_2$) des Phasenverschiebungsgesetzes von dem ersten Kanal (A) in Bezug auf die Frequenz parallel zu der repräsentativen Kurve ($CB_1$, $CB_2$) des Phasenverschiebungsgesetzes des zweiten Kanals (B) in Bezug auf die Frequenz in einem Frequenzband ist, **dadurch gekennzeichnet, dass** die Zellen (1) Allpass-Zellen sind, wobei die Komponenten ($L_1$, $L_2$, $C_1$, $C_2$) der Zellen (1) so definiert sind, dass sich in einem Kanal (A, B) die Kurven, die für die Phasenverschiebung der Zellen in Bezug auf die Frequenz repräsentativ sind ($CA_1$, $CA_2$ und $CB_1$, $CB_2$) verlängern, wobei jede Zelle dazu beiträgt, das Frequenzband zu verbreitern.

**2.** Vorrichtung nach Anspruch 1, **dadurch gekennzeichnet, dass** sie mehrere elementare Phasenregler (101, 102, 103, 104) in Kaskadenschaltung enthält.

**3.** Vorrichtung nach Anspruch 2, **dadurch gekennzeichnet, dass** die elementaren Phasenregler (101, 102, 103, 104) untereinander durch Umschalter (11, 12, 13) verbunden sind.

**4.** Vorrichtung nach Anspruch 3, **dadurch gekennzeichnet, dass** die Umschalter (11, 12, 13) Umschalter "2 zu 2" mit vier Zuständen sind.

**5.** Vorrichtung nach einem der Ansprüche 2 bis 4, **dadurch gekennzeichnet, dass** die Phasenverschiebung $\Delta\varphi$ von einem elementaren Phasenregler zum darauf folgenden mit einem Schritt $\phi/2^N$ variiert, wobei $\phi$ eine Referenzphasenverschiebung ist.

**6.** Vorrichtung nach einem der Ansprüche 3 bis 5, **dadurch gekennzeichnet, dass** die Umschalter (31, 11, 12, 13, 32) abwechselnd aktiv und passiv sind.

**7.** Vorrichtung nach einem der vorhergehenden Ansprüche, **dadurch gekennzeichnet, dass** der erste Umschalter (31), der den Eingang (E) auf dem ersten elementaren Phasenregler (101) umschaltet, aktiv ist.

**8.** Vorrichtung nach einem der vorhergehenden Ansprüche, **dadurch gekennzeichnet, dass** ein elementarer Phasenregler vier Zellen aufweist, zwei Zellen $A_1$, $A_2$ in dem ersten Kanal (A) und zwei Zellen $B_1$, $B_2$ in dem zweiten Kanal (B):

- die Zellen $A_1$, $B_1$, die einen Massekondensator ($C_1$) aufweisen, der mit dem Verbindungspunkt der Drosselspulen verbunden ist, der ferner mit dem Massepotenzial über eine metallisierte Bohrung (91) verbunden ist,
- die Zellen $A_2$, $B_2$, die einen Brückenkondensator ($C_2$) haben, der den Eingang mit dem Ausgang der Zelle verbindet, wobei jede Drosselspule ($L_1$, $L_2$) mit einem Kondensator ($C_1$) verbunden ist, der ferner mit der Masse verbunden ist, wobei eine Drosselspule ($L_1$) mit ihrem anderen Ende mit dem Eingang der Zelle verbunden ist, und die andere Drosselspule ($L_2$) mit ihrem anderen Ende mit dem Ausgang der Zelle verbunden ist.

**9.** Vorrichtung nach Anspruch 8, **dadurch gekennzeichnet, dass** die Zellen $A_1$, $B_1$ einen Brückenkondensator ($C_2$) haben, der auf Null reduziert ist.

**10.** Vorrichtung nach einem der Ansprüche 8 oder 9, **dadurch gekennzeichnet, dass** die Zellen $A_2$, $B_2$ einen Massekondensator ($C_1$) haben, der auf einen Kurzschluss reduziert ist.

**11.** Vorrichtung nach einem der Ansprüche 8 bis 10, **dadurch gekennzeichnet dass** der Kondensator ($C_1$) der Zellen $A_1$, $B_1$ mit dem Massepotenzial durch eine metallisierte Bohrung (91) verbunden ist.

**12.** Vorrichtung nach einem der Ansprüche 8 bis 11, **dadurch gekennzeichnet, dass** die Drosselspulen mit dem Massepotenzial über metallisierte Bohrungen (92, 93) verbunden sind.

**13.** Vorrichtung nach einem der vorhergehenden Ansprüche, **dadurch gekennzeichnet, dass** die Drosselspulen ($L_1$, $L_2$) der Zellen (1) verschachtelte Spiralen sind.

**14.** Vorrichtung nach einem der Ansprüche 1 bis 12, **dadurch gekennzeichnet, dass** die Drosselspulen übereinander gelagerte Spiralen mit mehreren metallischen Niveaus sind.

**15.** Vorrichtung nach einem der Ansprüche 13 oder 14, **dadurch gekennzeichnet, dass** die Spirale, die eine Drosselspule ($L_2$) bildet, in der Spirale enthalten ist, die die andere Drosselspule ($L_1$) bildet.

**16.** Vorrichtung nach einem der Ansprüche 13 oder 14, **dadurch gekennzeichnet, dass** die Spiralen versetzt sind.

**17.** Vorrichtung nach einem der Ansprüche 13 bis 16, **dadurch gekennzeichnet, dass** die Spiralen zu einer Achse (81) symmetrisch sind.

**18.** Vorrichtung nach einem der Ansprüche 13 bis 17, **dadurch gekennzeichnet, dass** die Spiralen leitende Pisten sind, die auf einem Träger hergestellt sind.

**19.** Vorrichtung nach Anspruch 18, **dadurch gekennzeichnet, dass** der Träger ein Galliumarsenid (AsGa) ist.

**20.** Vorrichtung nach einem der Ansprüche 18 oder 19, **dadurch gekennzeichnet, dass** die Pisten aus Gold sind.

FIG.1

FIG.2

FIG.3

**FIG.4**

**FIG.5**

FIG.6

EP 1 322 038 B1

FIG.7a

m = 0.0

FIG.7b

m = 0.3

FIG.7c

m = 0.5

FIG.7d

m = 0.6

FIG.8

FIG.9a

FIG.9b

FIG.10

| $\Delta\varphi$ | m | $A_1$ | | | $A_2$ | | | $B_1$ | | | $B_2$ | | |
|---|---|---|---|---|---|---|---|---|---|---|---|---|---|
| | | $L_1$ | $L_2$ | $C_1$ | $L_1$ | $L_2$ | $C_1$ | $L_1$ | $L_2$ | $C_2$ | $L_1$ | $L_2$ | $C_2$ |
| 11.25° | 0.5 | 1 | 1.2 | 0.1 | 4.2 | 5.1 | 0.4 | 0.9 | 1.1 | 0.1 | 4 | 4.8 | 0.4 |
| | 0.6 | 0.9 | 1.15 | 0.07 | 5.6 | 7.2 | 0.45 | 0.8 | 1 | 0.07 | 5.2 | 6.7 | 0.42 |
| 22.5° | 0.5 | 1 | 1.22 | 0.1 | 4.4 | 5.3 | 0.44 | 0.9 | 1.08 | 0.09 | 3.9 | 4.7 | 0.39 |
| | 0.6 | 0.9 | 1.16 | 0.07 | 6 | 7.6 | 0.48 | 0.8 | 1 | 0.06 | 5.1 | 6.6 | 0.41 |
| 45° | 0.5 | 1 | 1.25 | 0.1 | 4.9 | 5.9 | 0.49 | 0.8 | 0.97 | 0.08 | 3.8 | 4.6 | 0.38 |
| | 0.6 | 0.9 | 1.2 | 0.07 | 6.8 | 8.7 | 0.54 | 0.7 | 0.88 | 0.05 | 5 | 6.4 | 0.4 |
| 90° | 0.5 | 1.1 | 1.35 | 0.1 | 5.6 | 6.8 | 0.56 | 0.68 | 0.8 | 0.07 | 3.3 | 4 | 0.33 |
| | 0.6 | 1.1 | 1.38 | 0.09 | 7.9 | 10 | 0.63 | 0.6 | 0.8 | 0.05 | 4.3 | 5.5 | 0.34 |
| 180° | 0.5 | 1.5 | 1.7 | 0.15 | 7.8 | 9.3 | 0.77 | 0.5 | 0.6 | 0.05 | 2.7 | 3.2 | 0.27 |
| | 0.6 | 1.4 | 1.8 | 0.11 | 11.1 | 14 | 0.9 | 0.42 | 0.54 | 0.03 | 3.3 | 4.2 | 0.26 |

FIG.11

FIG.12

FIG.13